# EUROPEAN PATENT SPECIFICATION

(11) **EP 3 159 915 B1**
(45) Date of publication and mention of the grant of the patent: **06.12.2023**
(21) Application number: 15809896.2
(22) Date of filing: 11.06.2015
(51) Int. Cl.: H01L 21/304, B24B 37/00, C09K 3/14, B24B 37/04, C09G 1/02, H01L 21/306

(54) **METHOD FOR POLISHING SILICON WAFER, POLISHING COMPOSITION, AND POLISHING COMPOSITION SET**
VERFAHREN ZUM POLIEREN EINES SILICIUMWAFERS, POLIERZUSAMMENSETZUNG UND POLIERZUSAMMENSETZUNGSSATZ
PROCÉDÉ DE POLISSAGE DE PLAQUETTE DE SILICIUM, COMPOSITION DE POLISSAGE, ET ENSEMBLE DE COMPOSITION DE POLISSAGE

(30) Priority: 18.06.2014 JP 2014125792
(43) Date of publication of application: 26.04.2017
(73) Proprietor: Fujimi Incorporated, Kiyosu-shi, Aichi 452-8502 (JP)
(72) Inventor: TSUCHIYA, Kohsuke, Kiyosu-shi Aichi 452-8502 (JP); ASADA, Maki, Kiyosu-shi Aichi 452-8502 (JP)
(74) Representative: Grünecker Patent- und Rechtsanwälte PartG mbB
(86) International application number: PCT/JP2015/002927
(87) International publication number: WO 2015/194136

(56) References cited:
- EP-A2- 0 684 634
- WO-A1-2012/002525
- WO-A1-2012/039390
- DE-A1-102007 035 266
- JP-A- 2006 352 042
- US-B1- 6 189 546

## Description

### Technical Field

The present invention relates to a method for polishing a silicon wafer, and a polishing composition and a polishing composition set for use in the method.

### Background Art

The surface of a silicon wafer to be used as, for example, a component of a semiconductor product is commonly subjected to a lapping step (rough polishing step) and a polishing step (precision polishing step) to give a high-quality mirror surface. As technical documents on polishing of silicon wafers, PTLs 1 through 4 are exemplified, for example. PTL 5, forming the basis for the preamble of claim 1, relates to a method for polishing a substrate made of semiconductor material, comprising at least one polishing step of type A, with which the substrate is polished on a polishing cloth that contains an abrasive substance bound in the polishing cloth, with a polishing agent solution between the substrate and the polishing cloth during the polishing step polishing cloth is brought; and at least one Type B polishing step in which the substrate is polished on a polishing cloth containing an abrasive bound in the polishing cloth, wherein during the polishing step a slurry of polishing compound containing unbound abrasive is introduced between the substrate and the polishing cloth. PTL 6 discloses a method of rough polishing a semiconductor wafer to reduce roughness on a surface of the wafer prior to finish polishing the wafer by applying a polishing solution to a polishing material, contacting the polishing material and the polishing solution with the surface of the wafer as the wafer moves relative to the polishing material, applying a second polishing solution to the polishing material, and contacting the polishing material and the second polishing solution with the surface of the wafer as the wafer moves relative to the polishing material. PTL 7 discloses a multi-step polishing process for producing dopant-striation-free semiconductor wafers. The process includes polishing a surface of the wafer using a sodium stabilized colloidal silica slurry, an amine accelerant, and an alkaline etchant, polishing the surface of the wafer using a sodium stabilized colloidal silica slurry and an alkaline etchant which is substantially free of amine accelerants, and polishing the surface of the wafer using an ammonia stabilized colloidal silica slurry and an alkaline etchant which is substantially free of amine accelerants.

### Citation List

### Patent Literatures

PTL 1: WO 2012/002525
PTL 2: JP 11-140427 A
PTL 3: JP 2006-509364 T
PTL 4: JP 2011-097050 A
PTL 5: DE 10 2007 035266 A1
PTL 6: EP 0 684 634 A2
PTL 7: US 6 189 546 B1

### Summary of Invention

### Technical Problem

The polishing step is typically constituted by a plurality of polishing steps including a preliminary polishing step and a final polishing step. A silicon wafer is expected to have surface smoothness enhanced through sequential polishing with such polishing steps. In these polishing steps, different types of polishing slurries can be used in different polishing steps. For example, there is a tendency in which in a stage at which a silicon wafer is roughly polished (typically a primary polishing step), a polishing slurry having high processing power (polishing power) is used, whereas in a stage at which the silicon wafer is more finely polished (typically a final polishing step), a polishing slurry having low polishing power is used.

In such a case where a silicon wafer is polished by using a plurality of types of polishing slurries stepwise, these polishing slurries are individually designed or selected under different design concepts corresponding to different polishing steps. In a conventional technique in which a polishing slurry to be used is selected for each polishing step, however, quality enhancement of a finally obtained silicon wafer has limitations. For example, mismatches occur between a surface grade required after a final polishing step and a surface grade after completion of an intermediate polishing step performed consecutively before the final polishing step and between a polishing slurry used in the final polishing step and a polishing slurry used in the intermediate polishing step. These mismatches might hinder smoothness enhancement and defect reduction of a silicon wafer. With recent miniaturization of semiconductor wiring, higher grades have been required for silicon wafers, and a more precise polishing method has been demanded.

The present invention has been made in view of the foregoing circumstances, and has an object of providing a method for polishing a silicon wafer that can effectively obtain a high-grade surface after a final polishing step. Another related object of the present invention is to provide a polishing composition and a polishing composition set suitable for performing such a polishing method.

### Solution to Problem

According to the description, provided is a method for polishing a silicon wafer including: an intermediate polishing step of polishing a silicon wafer with a polishing slurry Sp containing abrasive grains and a water-soluble polymer; and a final polishing step of polishing the silicon wafer with a polishing slurry Sf containing abrasive grains and a water-soluble polymer. The final polishing step is performed after the intermediate polishing step, characterized in that the polishing slurry Sp contains the water-soluble polymer having a weight average molecular weight of 60 × 10⁴ or less, and the polishing slurry Sf contains the water-soluble polymer having a weight average molecular weight of 60 × 10⁴ or less and further contains a surfactant. In this polishing method, the polishing slurry Sp has a relative haze Hp greater than a relative haze Hf of the polishing slurry Sf and less than 6.8 times as high as the relative haze Hf of the polishing slurry Sf. Such a polishing method can prevent a mismatch between the polishing slurry Sp used in the intermediate polishing step and the polishing slurry Sf used in the final polishing step performed after the intermediate polishing step so that a high-grade surface of the silicon wafer can be efficiently obtained.

Here, the relative haze Hp of the polishing slurry Sp used in the intermediate polishing step refers to a value calculated in accordance with an equation: Hp = (hp/h₀) × 100 from a haze value (haze reference value) h₀ obtained in the case of polishing the silicon wafer with a standard slurry II described later and a haze value (haze measured value) hp obtained in the case of polishing the silicon wafer with the standard slurry II and then further polishing the silicon wafer with the polishing slurry Sp. That is, the relative haze Hp corresponds to a value obtained by converting the haze measured value hp measured by using the polishing slurry Sp to a relative value determined by using the haze reference value h₀ as 100. Similarly, the relative haze Hf of the polishing slurry Sf used in the final polishing step refers to a value calculated in accordance with an equation: Hf = (hf/h₀) × 100 from a haze value (haze reference value) h₀ obtained in the case of polishing the silicon wafer with the standard slurry II described later and a haze value (haze measured value) hf obtained in the case of polishing the silicon wafer with the standard slurry II and then further polishing the silicon wafer with the polishing slurry Sf. Methods for measuring Hp and Hf will be specifically described later.

The relative haze Hf of the polishing slurry Sf is preferably 120 or less. By performing the final polishing step using the polishing slurry Sf having the relative haze Hf after the intermediate polishing step using the polishing slurry Sp, a high-grade surface can be effectively obtained.

The relative haze Hp of the polishing slurry Sp is preferably more than 120 and 500 or less. By performing the final polishing step using the polishing slurry Sf after the intermediate polishing step using the polishing slurry Sp, the surface grade of the silicon wafer can be effectively enhanced.

The polishing slurry Sp contains a water-soluble polymer. The use of the polishing slurry Sp having such a composition tends to ease obtaining of a surface appropriate for the final polishing step using the polishing slurry Sf. The water-soluble polymer preferably has a weight average molecular weight (Mw) of 1 × 10⁴ or more and 60 × 10⁴ or less, for example.

The polishing slurry Sf contains a surfactant. A higher-grade surface of the silicon wafer tends to be obtained by performing the final polishing step using the polishing slurry Sf containing the surfactant after the intermediate polishing step using the polishing slurry Sp. The surfactant preferably has a molecular weight (Mw) of 200 or more and less than 10000, for example.

According to the description, provided is a method for polishing a silicon wafer, utilizing a polishing composition for use in the intermediate polishing step of any one of the methods for polishing a silicon wafer disclosed here. The polishing composition can be the polishing slurry Sp in the polishing method or a concentrated liquid of the polishing slurry Sp. The polishing method can be preferably performed by using the polishing composition.

According to the description, provided is a method for polishing a silicon wafer, utilizing a polishing composition for use in the final polishing step of any one of the methods for polishing a silicon wafer disclosed here. The polishing composition can be the polishing slurry Sf in the polishing method or a concentrated liquid of the polishing slurry Sf. The polishing method can be preferably performed by using the polishing composition.

According to the description, provided is a method for polishing a silicon wafer, utilizing a polishing composition set including a first polishing composition and a second polishing composition that are separately stored. The first polishing composition can be the polishing slurry Sp for use in the intermediate polishing step of one of the methods for polishing a silicon wafer disclosed here or a concentrated liquid of the polishing slurry Sp. The second polishing composition can be the polishing slurry Sf for use in the final polishing step of any one of the methods for polishing a silicon wafer disclosed here or a concentrated liquid of the polishing slurry Sf. The polishing method can be preferably performed by using the polishing composition set.

### Description of Embodiment

A preferred embodiment of the present invention will be hereinafter described. Matters not specifically mentioned in the description but required for carrying out the present invention can be understood as matters of design variation of a person skilled in the art based on related art in the field. The present invention can be carried out on the basis of the contents disclosed in the description and common general knowledge in the field.

In the description, the term "X to Y" indicating a numerical range refers to "X or more and Y or less," "weight" and "mass" are used as synonyms, "% by weight" and "% by mass" are used as synonyms, and "part(s) by weight" and "part(s) by mass" are used as synonyms.

A method for polishing a silicon wafer disclosed here includes an intermediate polishing step of polishing a polishing object (a silicon wafer in this embodiment) with a polishing slurry Sp and a final polishing step of polishing the polishing object subjected to the intermediate polishing step with a polishing slurry Sf.

The "final polishing step" includes a polishing step that is performed lastly (i.e., disposed at the most downstream side) in polishing steps performed using polishing slurries containing abrasive grains. Thus, the polishing slurry Sf in the technique disclosed here can be understood as a polishing slurry of a type used at the most downstream side among a plurality of types of polishing slurries used in a polishing process of a silicon wafer. In the description, the final polishing step herein includes a polishing step that is performed consecutively before the last polishing step and uses a polishing slurry Sf having the same composition as that in the last polishing step. That is, the final polishing step in the technique disclosed here can be two or more polishing steps as long as the polishing slurry Sf having the same composition as that used in the last polishing step is used and the final polishing step is consecutively disposed before the last polishing step.

The "intermediate polishing step" includes a polishing step that is performed with a polishing slurry containing abrasive grains and is disposed immediately before the final polishing step. That is, the intermediate polishing step includes a polishing step that is disposed at the most downstream side among the polishing steps performed before the final polishing step. Thus, the polishing slurry Sp in the technique disclosed here can be a polishing slurry of a type that is used for the second time from the downstream side among a plurality of types of polishing slurries used in the polishing process of the silicon wafer. In the description, the intermediate polishing step herein includes a polishing step that is consecutively performed before the polishing step immediately before the final polishing step and uses a polishing slurry Sp having the same composition as that used in the polishing step immediately before the final polishing step. That is, the intermediate polishing step in the technique disclosed here can include two or more polishing steps as long as the polishing slurry Sp having the same composition as that used in the polishing step immediately before the final polishing step is used and the intermediate polishing step is consecutively disposed before the polishing step immediately before the final polishing step.

In the following description, the polishing slurry Sp used in the intermediate polishing step will be sometimes referred to as an "intermediate polishing slurry Sp" and the polishing slurry Sf used in the final polishing step will be sometimes referred to as a "final polishing slurry Sf."

### <Relative Haze>

The intermediate polishing slurry Sp in the technique disclosed here is appropriately a polishing slurry having a relative haze Hp greater than a relative haze Hf of the final polishing slurry Sf. The intermediate polishing slurry Sp preferably has a relative haze Hp greater than a relative haze Hf of the polishing slurry Sf and less than 6.8 times as high as the relative haze Hf of the polishing slurry Sf. That is, the relation between Hp and Hf preferably satisfies 1 < (Hp/Hf) < 6.8. Such an intermediate polishing slurry Sp tends to exhibit a high degree of matching with the final polishing slurry Sf. Thus, the use of the intermediate polishing slurry Sp and the final polishing slurry Sf satisfying the relation described above can effectively obtain a high-grade surface of a silicon wafer. For example, the number of defects (LPD-N number), such as light point defect non-cleanable (LPD-N), can be appropriately reduced. The ratio of Hp/Hf is preferably 1.05 or more, and more preferably 1.1 or more. With an increase of the ratio of Hp/Hf, the intermediate polishing slurry Sp is typically allowed to have a composition enabling a higher polishing rate so that a total polishing time tends to be easily shortened. With a decrease of a haze to some degree after polishing with the intermediate polishing slurry Sp, a load of the final polishing slurry Sf in reducing haze tends to decrease so that a surface with a reduced number of defects can be easily obtained. In view of this, the ratio of Hp/Hf is preferably 5 or less, and more preferably 4.5 or less.

In the description, a relative haze of a polishing slurry Sx (where x = p or f, the same holds hereinafter) will be referred to as Hx (where x = p or f, the same holds hereinafter) . The relative haze Hx can be measured in the manner described below. More specifically, the relative haze Hx can be measured in the manner described in examples below.

### [Relative Haze Measuring Method]

### (1) Measurement of Haze Reference Value h₀

A commercially available polished silicon wafer is subjected to a pretreatment X described below and then to SC-1 cleaning and isopropyl alcohol (IPA) vapor drying described in examples below, and a haze value (ppm) is measured. This haze value will be hereinafter referred to as a "haze reference value h₀." A silicon wafer to be used is a p-type silicon wafer having a diameter of 300 mm, a crystal orientation of <100>, and a resistivity of 0.1 Ω·cm or more and less than 100 Ω·cm.

### (Pretreatment X)

(i) A commercially available polished silicon wafer is polished using a standard slurry I described later as a polishing slurry under conditions (conditions 1) of a polishing load: 20 kPa, a supply rate of polishing slurry: 1.0 liter/min (free-flowing), and a polishing time: 3 minutes.
(ii) Subsequently, the silicon wafer is rinsed with a rinse solution described later.
(iii) Thereafter, using a standard slurry II described later as a polishing slurry, the silicon wafer is polished under conditions (conditions 2) of a polishing load: 15 kPa, a supply rate of polishing slurry: 2.0 liter/min (free-flowing), and a polishing time: 3 minutes.

### (2) Measurement of Haze Measured Value hx

A commercially available polished silicon wafer is subjected to a pretreatment X in a manner similar to that in the measurement of the haze reference value h₀. The silicon wafer subjected to the pretreatment X is polished using a polishing slurry Sx under conditions (conditions 2) of a polishing load: 15 kPa, a supply rate of polishing slurry: 2.0 liter/min (free-flowing), and a polishing time: 3minutes, and then a haze value (ppm) is measured. This haze value will be hereinafter referred to as a "haze measured value hx."

### (3) Calculation of Relative Haze Hx

A relative haze Hx of a polishing slurry Sx is calculated by an equation: Hx = (hx/h₀) × 100.

Here, compositions of the standard slurry I and the standard slurry II used in the relative haze Hx measuring method described above are as follows:
(Standard Slurry I)
colloidal silica: 0.95 % by weight
potassium hydroxide: 0.065 % by weight
remainder: water
(Standard Slurry II)
colloidal silica: 0.46 % by weight
ammonia: 0.009 % by weight
hydroxyethyl cellulose (having an Mw of 25 × 10⁴): 0.017 % by weight
PEO-PPO-PEO block copolymer: 0.002 % by weight
remainder: water
(Rinse Solution)
ammonia: 0.0005 % by weight
hydroxyethyl cellulose (having an Mw of 25 × 10⁴): 0.013 % by weight
remainder: water

Here, colloidal silica in each of the standard slurry I and the standard slurry II may have an average primary particle size of 33 to 36 nm (typically about 35 nm) and an average secondary particle size of 55 to 70 nm (typically about 66 nm) .

Hydroxyethyl cellulose (HEC) in the standard slurry II may have a weight average molecular weight (Mw) of 22 × 10⁴ to 27 × 10⁴ (typically about 25 × 10⁴).

A PEO-PPO-PEO block copolymer in the standard slurry II may be a triblock copolymer including polyethylene oxide block (PEO) at each side of polypropylene oxide block (PPO) and having an Mw of 8500 to 9500 (typically about 9000) and a weight ratio (EO:PO) of ethylene oxide (EO) to propylene oxide (PO) of 75:25 to 85:15 (typically about 80:20).

The relative haze Hf of the final polishing slurry Sf is not limited to particular values. As the final polishing slurry Sf, a polishing slurry satisfying a relation of (Hp/Hf) in the preferred range described above with respect to the relative haze Hp of the intermediate polishing slurry Sp can be used as appropriate. For example, a final polishing slurry Sf having an Hf of 300 or less can be used. From the viewpoint of the surface grade after the final polishing step, the Hf of the final polishing slurry Sf is appropriately 250 or less, preferably 200 or less, and more preferably 180 or less.

The polishing method disclosed here can be preferably performed in an embodiment in which a final polishing slurry Sf having a relative haze Hf of 150 or less is used. A decrease of a relative haze tends to reduce processing power of a polishing object. The polishing slurry Sf having such weak processing power easily causes a mismatch with the polishing slurry Sp used in the intermediate polishing step, but when being used for polishing of a surface appropriately adjusted in the intermediate polishing step, can obtain a high-grade surface. Thus, application of the technique disclosed here is significant in preventing a mismatch between the polishing slurry Sp and the polishing slurry Sf. The mismatch herein refers to, for example, a failure in obtaining a preferable surface grade in the final polishing step using the polishing slurry Sf because of the surface grade of a polishing object after the intermediate polishing step using the polishing slurry Sp. The Hf of the polishing slurry Sf is preferably 130 or less, more preferably 110 or less, and especially preferably 100 or less (e.g., 95 or less, and furthermore, 90 or less) . With a decrease of the Hf of the polishing slurry Sf, a higher-grade surface tends to be obtained in the final polishing step using the polishing slurry Sf.

The lower limit of the Hf is not limited to particular values, and only needs to be greater than zero. From the viewpoint of, for example, polishing efficiency, the Hf is appropriately 10 or more, preferably 30 or more, and more preferably 50 or more (e.g., 70 or more), in general.

The relative haze Hp of the intermediate polishing slurry Sp is not limited to particular values. As the intermediate polishing slurry Sp, a polishing slurry having a ratio of (Hp/Hf) in the preferable ranges described above can be appropriately employed. For example, an intermediate polishing slurry Sp having an Hp of 2000 or less (typically 1000 or less) is preferably used. From the viewpoint of surface grade after the subsequent final polishing step, the Hp of the intermediate polishing slurry Sp is appropriately 800 or less, preferably 500 or less, more preferably 450 or less, and especially preferably 300 or less (e.g., 250 or less), in general.

From the viewpoint of, for example, polishing efficiency, the Hp is appropriately more than 30, preferably more than 60, more preferably more than 100, and even more preferably more than 120 (e.g., more than 150), in general.

### <Polishing Rate Index>

In the technique disclosed here, the polishing slurry Sp preferably has a polishing rate index Rp greater than a polishing rate index Rf of the polishing slurry Sf and less than 15 times as large as the polishing rate index Rf of the polishing slurry Sf. That is, a relation between Rp and Rf preferably satisfies 1 < (Rp/Rf) < 15. The setting of (Rp/Rf) in the range described above can enhance a polishing efficiency (productivity) of a silicon wafer while preventing a mismatch between the polishing slurry Sp and the polishing slurry Sf. The relation between Rp and Rf more preferably satisfies 2 < (Rp/Rf) < 10.

In the description, the polishing rate index of the polishing slurry Sx will be hereinafter referred to as Rx (where x = p or f, the same holds hereinafter) . The polishing rate index Rx can be measured in the following manner. More specifically, the polishing rate index Rx can be measured in the manner described in examples below.

### [Method for Measuring Polishing Rate Index]

### (1) Preparation of Test Sample

A commercially available polished silicon wafer is subjected to the pretreatment X described above, to SC-1 cleaning described later, and then to IPA vapor drying described later. The resulting wafer is cut into a 32-mm square, thereby preparing a test sample . As the silicon wafer, a p-type silicon wafer having a diameter of 200 mm, a crystal orientation of <100>, and a resistivity of 0.1 Ω·cm or more and less than 100 Ω·cm is used.

### (2) Measurement of Rate Reference Value r₀

Before polishing of the test sample, the test sample is subjected to a hydrogen fluoride process so that an oxide film on the silicon wafer is removed. Thereafter, using the standard slurry II described above as a polishing slurry, the silicon wafer is polished under conditions (conditions 3) of a polishing load: 15 kPa, a supply rate of polishing slurry: 0.12 liter/min (free-flowing), and a polishing time: 30 minutes, and a polishing rate (nm/min) is calculated from a difference in the weight of the test sample before and after the polishing. This polishing rate will be hereinafter referred to as a "rate reference value r₀."

### (3) Measurement of Rate Measured Value rx

The test sample is subjected to the hydrogen fluoride process so that the oxide film on the silicon wafer is removed, and thereafter, the silicon wafer is polished using the polishing slurry Sx under conditions (conditions 3) of a polishing load: 15 kPa, a supply rate of polishing slurry: 0.12 liter/min (free-flowing), and a polishing time: 30 minutes, and a polishing rate (nm/min) is calculated from a difference in the weight of the test sample before and after the polishing. The polishing rate will be hereinafter referred to as a "rate measured value rx."

### (4) Calculation of Polishing Rate Index Rx

A polishing rate index Rx of the polishing slurry Sx is calculated from an equation: Rx = (rx/r₀) × 100.

A silicon wafer used in the relative haze measuring method or the method for measuring a polishing rate index preferably has a small amount of crystal defects (crystal originated particle: COP) or hardly has COP. For example, a silicon wafer generally distributed as "COP-free" can be preferably used.

The polishing rate index Rp of the intermediate polishing slurry Sp is not limited to particular values. As the intermediate polishing slurry Sp, a polishing slurry having a ratio of (Rp/Rf) in the preferable ranges described above can be appropriately employed. From the viewpoint of, for example, polishing efficiency of a silicon wafer, the polishing rate index Rp of the intermediate polishing slurry Sp is appropriately 50 or more, preferably 100 or more, more preferably 200 or more, and even more preferably 300 or more (e.g., 350 or more).

The upper limit of the Rp is not limited to particular values. From the viewpoint of surface grade after the subsequent final polishing step, an intermediate polishing slurry Sp having an Rp of less than 1000 is advantageously used. The Rp of the intermediate polishing slurry Sp is preferably 700 or less and more preferably 500 or less.

The polishing rate index Rf of the final polishing slurry Sf is not limited to particular values. As the final polishing slurry Sf, a polishing slurry having a ratio of (Rp/Rf) in the preferable ranges described above can be appropriately employed. From the viewpoint of surface grade after the final polishing step, a final polishing slurry Sf having an Rp of 400 or less is advantageously used. The Rf of the final polishing slurry Sf is appropriately 300 or less, preferably 200 or less, and more preferably 150 or less (e.g., 120 or less), in general. In the technique disclosed here, the polishing rate index Rf of the final polishing slurry Sf may be 100 or less (e.g., 80 or less, and furthermore, 70 or less).

The lower limit of the polishing rate index Rf is not limited to particular values. From the viewpoint of, for example, polishing efficiency, the polishing rate index Rf is appropriately 20 or more, preferably 40 or more, and more preferably 50 or more, in general.

The polishing method disclosed here can include another optional polishing step before the intermediate polishing step, in addition to the intermediate polishing step and the final polishing step. As the optional polishing step, the polishing method typically includes a lapping step disposed upstream of the intermediate polishing step. The intermediate polishing step can be a part or the whole of the preliminary polishing step disposed between the lapping step and the final polishing step. In a case where the intermediate polishing step is a part of the preliminary polishing step, the preliminary polishing step includes one or more polishing steps (hereinafter referred to as "initial polishing steps") before the intermediate polishing step. A polishing slurry used in the initial polishing step is not limited to particular types. For example, a polishing slurry having a polishing rate index larger than that of the intermediate polishing slurry Sp can be preferably used as a polishing slurry for the initial polishing step.

The following description is mainly directed to the polishing slurry Sp used in the intermediate polishing step and the polishing slurry Sf used in the final polishing step. Preferred examples are applicable to all the polishing slurries Sp and Sf and the polishing slurry for the initial polishing step used as necessary, unless otherwise specified.

### <Abrasive Grains>

Each polishing slurry used in the polishing method disclosed here contains abrasive grains. A material and properties of abrasive grains are not specifically limited, and can be appropriately selected depending on, for example, a purpose, a state, and a period of use of the polishing slurry. Examples of the abrasive grains include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and colcothar particles; nitride particles such as silicon nitride particles and boron nitride particles; carbide particles such as silicon carbide particles and boron carbide particles; diamond particles; and carbonates such as calcium carbonate and barium carbonate. Specific examples of the organic particles include polymethyl methacrylate (PMMA) particles, poly(meth)acrylic acid particles (here, the (meth)acrylic acid inclusively means acrylic acid and methacrylic acid), and polyacrylonitrile particles. Examples of the organic-inorganic composite particles include particles in which the surfaces of inorganic particles are modified by organic compounds, particles in which inorganic particles are attached to the surfaces of organic particles (including rubber particles), and particles of an organic-inorganic composite material. Such abrasive grain types may be used singly or in combination of two or more of them.

The abrasive grains are preferably inorganic particles, and especially preferably particles of a metal oxide or a metalloid oxide. The abrasive grains usable in the technique disclosed here are preferably exemplified by silica particles. The reason for this is as follows: When silica particles composed of oxygen atoms and the same element as a silicon wafer, which is an object to be polished, are used as the abrasive grains, residues of a different metal or a different metalloid from silicon are not generated after polishing, and this eliminates the possibility of contamination of the surface of the silicon wafer or of deterioration of electrical properties as the silicon wafer due to diffusion of a different metal or a different metalloid from silicon in an object to be polished. As a preferred embodiment of the polishing slurry from such a viewpoint, a polishing slurry containing silica particles alone as the abrasive grains is exemplified. In addition, silica has such characteristics that highly pure silica is easily available. This is also exemplified as the reason why the silica particles are preferred as the abrasive grains. Specific examples of the silica particles include colloidal silica, fumed silica, and precipitated silica. From the viewpoints that scratches are unlikely to be generated on the surface of a silicon wafer and a surface having a lower haze can be achieved, preferred examples of the silica particles include colloidal silica and fumed silica. Of them, colloidal silica is preferred.

The silica constituting the silica particles has a true specific gravity of preferably 1.5 or more, more preferably 1.6 or more, and even more preferably 1.7 or more. Silica having a larger true specific gravity enables an improvement of polishing rate (the removal amount of the surface of an object to be polished per unit time) at the time of polishing of a silicon wafer. From the viewpoint of reducing scratches generated on the surface (polished face) of an object to be polished, silica particles having a true specific gravity of 2.2 or less are preferred. As the true specific gravity of silica, a measured value determined by a liquid displacement method using ethanol as a displacement liquid can be adopted.

In the technique disclosed here, the abrasive grains included in each polishing slurry may be in the form of primary particles or in the form of secondary particles formed by assembly of a plurality of primary particles. Abrasive grains in the form of primary particles may be mixed with abrasive grains in the form of secondary particles. In a preferred embodiment, at least some of the abrasive grains are contained in the form of secondary particles in the polishing slurry.

Here, in the description, an average particle size of primary particles of abrasive grains contained in the polishing slurry Sx (where x = p or f, the same holds hereinafter) will be hereinafter referred to as D₁ₓ (nm) . The average primary particle size D₁ₓ can be, for example, calculated in accordance with an equation, D₁ₓ (nm) = 2727/S where S is a specific surface area (m²/g) determined by a BET method. The specific surface area of abrasive grains can be determined by using a surface area analyzer, trade name "Flow Sorb II 2300" manufactured by Micromeritics, for example.

In the technique disclosed here, the average primary particle size D₁ₚ of the abrasive grains used in the polishing slurry Sp for the intermediate polishing step is not limited to particular values. In a preferred embodiment, the D₁ₚ is 5 nm or more, and is more preferably 10 nm or more. With an increase of the D₁ₚ, a higher polishing rate can be obtained. From the viewpoint of obtaining higher polishing power, the D₁ₚ is preferably 15 nm or more, and more preferably 20 nm or more. From the viewpoint of easiness in obtaining a smoother surface, the D₁ₚ is preferably 100 nm or less, more preferably 60 nm or less, and even more preferably 50 nm or less (e.g., 40 nm or less).

In the technique disclosed here, the average primary particle size D_{1f} of abrasive grains used in the polishing slurry Sf for final polishing is not limited to particular values. In a preferred embodiment, the D_{1f} is 5 nm or more, and more preferably 10 nm or more. With an increase of the D_{1f}, a higher polishing rate can be obtained. From the viewpoint of obtaining higher polishing power, the D_{1f} is preferably 15 nm or more, and more preferably 20 nm or more. From the viewpoint of easiness in obtaining a smoother surface, the D_{1f} is appropriately 150 nm or less in general, and is preferably 100 nm or less, more preferably 60 nm or less, and even more preferably 50 nm or less (e.g., 40 nm or less, and furthermore, 30 nm or less).

In the description, an average secondary particle size of abrasive grains used in the polishing slurry Sx will be hereinafter referred to as D_{Vx} (nm). The average secondary particle size D_{Vx} can be determined as an arithmetic average diameter based on volume by dynamic light scattering using a model "UPA-UT151" manufactured by NIKKISO CO., LTD., for example. In the description, the average secondary particle size D_{Vx} refers to a numerical part of the average particle size based of a unit of nm, and the D_{Vx} is a dimensionless quantity.

In the technique disclosed here, the average secondary particle size D_{Vp} (nm) of abrasive grains contained in the intermediate polishing slurry Sp is appropriately 20 nm or more in general, and is preferably 30 nm or more, more preferably 40 nm or more, and even more preferably 50 nm or more (e.g., 60 nm or more) . When the D_{Vp} is the above-described lower limit or more, a surface (a surface to be polished) suitable for the subsequent final polishing step can be efficiently obtained in the intermediate polishing step. From the viewpoints of reduction of detects and enhancement of surface smoothness, the D_{Vp} is appropriately 250 nm or less, preferably 200 nm or less, and more preferably 150 nm or less (e.g., 100 nm or less).

In the technique disclosed here, the average secondary particle size D_{Vf} (nm) of abrasive grains contained in the polishing slurry Sf for the final polishing step is appropriately 20 nm or more in general, and is preferably 30 nm or more, more preferably 40 nm or more, and even more preferably 50 nm or more (e.g., 55 nm or more) . When the D_{Vf} is the above-described lower limit or more, the abrasive grains can have polishing power appropriate for the silicon wafer surface after the intermediate polishing step. From the viewpoints of reduction of detects and enhancement of surface smoothness, the D_{Vf} is appropriately 250 nm or less, preferably 200 nm or less, and more preferably 150 nm or less (e.g., 100 nm or less, and furthermore, 80 nm or less).

The average secondary particle size D_{Vx} (nm) of abrasive grains is substantially equal to or greater than the average primary particle size D₁ₓ (nm) of the abrasive grains (i.e., D_{Vx}/D₁ₓ ≥ 1) in general, and is typically greater than D₁ₓ (nm) (i.e., D_{Vx}/D₁ₓ > 1). Although not critical, from the viewpoints of polishing effect and surface smoothness after polishing, D_{Vx}/D₁ₓ is appropriately in the range from 1.0 to 3.5 in general, preferably in the range from 1.05 to 3, and more preferably in the range from 1.1 to 2.5.

The shape (outer shape) of abrasive grains may be spherical or nonspherical. Specific examples of the shape of nonspherical abrasive grains include a peanut-like shape (or a peanut shell-like shape), a cocoon-like shape, a konpeito (small ball-shaped candy with horn-like prongs on the surface) like shape, and a rugby ball-like shape. For example, abrasive grains in which many of the abrasive grains have a peanut-like shape can be preferably adopted.

The average of major axis length/minor axis length ratios (average aspect ratio) of primary particles of the abrasive grains is not limited to particular values, but is typically 1.0 or more, preferably 1.05 or more, and more preferably 1.1 or more. When the abrasive grains have a larger average aspect ratio, a higher polishing rate can be achieved. The abrasive grains preferably have an average aspect ratio of 3.0 or less, more preferably 2.0 or less, and even more preferably 1.5 or less from the viewpoint of reducing scratches, for example.

The shape (outer shape) and the average aspect ratio of the abrasive grains can be determined by observation under an electron microscope, for example. Specific procedures for determining the average aspect ratio are as follows: For example, a predetermined number (for example, 200 pieces) of abrasive grains that can be identified to have independent particle shapes are observed under a scanning electron microscope (SEM), and a rectangle is circumscribed around each grain image so as to have a minimum area. The long side length (major axis length) of the rectangle circumscribing each grain image is divided by the short side length (minor axis length), and the calculated value is regarded as the major axis length/minor axis length ratio (aspect ratio). The arithmetic mean of the aspect ratios of the predetermined number of grains can be calculated to give the average aspect ratio.

### <Water>

Each polishing slurry disclosed here typically contains water. Preferred examples of water include ion-exchanged water (deionized water), pure water, ultrapure water, and distilled water. In the water used, the total content of transition metal ions is preferably 100 ppb or less, for example, in order to minimize inhibition of functions of other components contained in the polishing slurry For example, the water purity can be increased by an ion exchange resin to remove impurity ions, by a filter to remove foreign substances, distillation, or similar operations.

The polishing slurry disclosed here may further contain an organic solvent homogeneously miscible with water (e.g., lower alcohols and lower ketones), as needed. Typically, 90% by volume or more of the solvent contained in the polishing slurry is preferably water, and 95% by volume or more (typically, 99 to 100% by volume) of the solvent is more preferably water.

### <Basic Compound>

Each polishing slurry disclosed here typically contains a basic compound. The basic compound herein refers to a compound having the function of increasing the pH of the polishing slurry when being added to the polishing slurry. The basic compound has the function of chemically polishing a surface of a silicon wafer to be polished and can contribute to an increase of a polishing rate. The basic compound can be useful for enhancing dispersion stability of the polishing slurry.

As the basic compound, nitrogen-containing organic or inorganic basic compounds, hydroxides of alkali metals or alkaline earth metals, various carbonates, and hydrogen carbonates, for example, can be used. Examples of the basic compound include hydroxides of alkali metals, hydroxides of quaternary ammoniums or salts thereof, ammonia, and amines. Specific examples of the hydroxides of alkali metals include potassium hydroxide and sodium hydroxide. Specific examples of the carbonates or the hydrogen carbonates include ammonium hydrogen carbonate, ammonium carbonate, potassium hydrogen carbonate, potassium carbonate, sodium hydrogen carbonate, and sodium carbonate. Specific examples of the hydroxides of quaternary ammoniums or salts thereof include tetramethylammonium hydroxide, choline, tetraethylammonium hydroxide, and tetrabutylammonium hydroxide. Specific examples of the amines include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl)piperazine, N-methylpiperazine, guanidine, and azoles such as imidazole and triazole. These basic compounds can be used singly or in combination of two or more of them.

Preferred examples of the basic compound from the viewpoint of, for example, an increase of the polishing rate include ammonia, potassium hydroxide, sodium hydroxide, tetramethylammonium hydroxide, choline, tetraethylammonium hydroxide, ammonium hydrogen carbonate, ammonium carbonate, potassium hydrogen carbonate, potassium carbonate, sodium hydrogen carbonate, and sodium carbonate. Specifically preferred examples include ammonia, potassium hydroxide, sodium hydroxide, tetramethylammonium hydroxide, choline, and tetraethylammonium hydroxide. More preferred examples include ammonia and tetramethylammonium hydroxide.

In the case of using the basic compound, the content of the basic compound in the polishing slurry is not limited to particular values. From the viewpoint of, for example, an increase of the polishing rate, the content is preferably 0.001% by weight or more of the polishing slurry and more preferably 0.005 % by weight or more of the polishing slurry in general. From the viewpoint of, for example, haze reduction, the content is preferably less than 0.4% by weight and more preferably less than 0.25% by weight.

In a preferred embodiment of the technique disclosed here, the content of the basic compound in the intermediate polishing slurry Sp can be larger than the content of the basic compound in the final polishing slurry Sf. For example, the content of the basic compound in the intermediate polishing slurry Sp can be 0.01% by weight or more (typically 0.01% by weight or more and less than 0.4% by weight), and the content of the basic compound in the final polishing slurry Sf can be less than 0.01% by weight (typically 0.001% by weight or more and less than 0.01% by weight).

The pH of the polishing slurry is not limited to particular values. For example, the pH is preferably 8.0 to 12.0 and more preferably 9.0 to 11.0. The basic compound is preferably contained so that the pH of the polishing slurry is in the above-described ranges.

### <Water-Soluble Polymer>

Each polishing slurry disclosed here contains a water-soluble polymer as necessary. The type of the water-soluble polymer that can be contained in the polishing slurry disclosed here is not limited to particular types . The water-soluble polymer may be used singly or in combination of two or more of them.

The water-soluble polymer has, in the molecule, at least one functional group selected from cationic groups, anionic groups, and nonionic groups. The water-soluble polymer can be, for example, a polymer having, in the molecule, a hydroxy group, a carboxyl group, an acyloxy group, a sulfo group, a quaternary nitrogen structure, a heterocyclic structure, a vinyl structure, a polyoxyalkylene structure, or the like.

Examples of the water-soluble polymer preferably usable in the polishing slurry disclosed here include polymers containing a cellulose derivative and an oxyalkylene unit; polymers containing N-vinyl type monomer units such as N-vinyl lactam and N-vinyl chain amide; polymers containing an imine derivative and an N-(meth)acryloyl type monomer unit; vinyl alcohol polymers such as polyvinyl alcohol and derivatives thereof; and pullulan.

Specific examples of the cellulose derivative (hereinafter also referred to as a "water-soluble polymer PA") include hydroxyethyl cellulose (HEC), hydroxypropyl cellulose, hydroxyethylmethyl cellulose, hydroxypropylmethyl cellulose, methyl cellulose, ethyl cellulose, ethylhydroxyethyl cellulose, and carboxymethyl cellulose. Of them, hydroxyethyl cellulose is preferred.

The polymer containing an oxyalkylene unit (hereinafter also referred to as a "water-soluble polymer PB") can be a polymer including one or more types of oxyalkylene units having a carbon atom number of 2 to 6 (typically a structure unit expressed as -CₙH₂ₙO- where n is an integer of 2 to 6) . A polymer in which the carbon atom number of the oxyalkylene unit is 2 to 3 is preferred. Examples of such a polymer include polyethylene oxide, a block copolymer of ethylene oxide (EO) and propylene oxide (PO), and a random copolymer of EO and PO.

The block copolymer of EO and PO can be, for example, a diblock copolymer or a triblock copolymer including a polyethylene oxide block (PEO) and a polypropylene oxide block (PPO). Examples of the triblock copolymer include a PEO-PPO-PEO type triblock copolymer and a PPO-PEO-PPO type triblock copolymer. Of them, the PEO-PPO-PEO type triblock copolymer is preferred.

The PEO-PPO-PEO type triblock copolymer is preferably a polymer expressed by General Formula (1):

HO-(EO)ₐ-(PO)_{b}-(EO)_{c}-H (1)

where EO is an oxyethylene unit (-CH₂CH₂O-), PO is an oxypropylene unit (-CH₂CH(CH₃)O-) group, and each of a, b, and c is an integer of 1 or more (typically 2 or more).

In General Formula (1), the sum of a and c is preferably in the range from 2 to 1000, more preferably in the range from 5 to 500, and even more preferably in the range from 10 to 200. In General Formula (1), b is preferably in the range from 2 to 200, more preferably in the range from 5 to 100, and even more preferably in the range from 10 to 50.

In the block copolymer or the random copolymer of EO and PO, from the viewpoints of, for example, water solubility and cleanability, the molar proportion of EO and PO (EO/PO) constituting the copolymer is preferably more than 1, more preferably 2 or more, and even more preferably 3 or more (e.g., 5 or more).

Examples of the polymer containing an N-vinyl type monomer unit (hereinafter also referred to as a "water-soluble polymer PC") include a homopolymer of an N-vinyl lactam type monomer and a copolymer of an N-vinyl lactam type monomer (e.g., a copolymer in which a copolymerization proportion of the N-vinyl lactam type monomer exceeds 50% by weight) and a homopolymer of an N-vinyl chain amide and a copolymer of an N-vinyl chain amide (e.g., a copolymer in which a copolymerization proportion of the N-vinyl chain amide exceeds 50% by weight).

In the description, unless otherwise specified, the term copolymer inclusively means various types of copolymers such as a random copolymer, an alternating copolymer, a block copolymer, and a graft copolymer.

Specific example of the N-vinyl lactam type monomer include N-vinylpyrrolidone (VP), N-vinylpiperidone, N-vinylmorpholinone, N-vinylcaprolactam (VC), N-vinyl-1,3-oxazine-2-one, and N-vinyl-3,5-morpholinedione. Specific examples of the polymer containing an N-vinyl lactam type monomer unit include polyvinylpyrrolidone, polyvinylcaprolactam, a random copolymer of VP and VC, a random copolymer of one or both of VP and VC and another vinyl monomer (e.g., an acrylic monomer and a vinyl ester-based monomer), a block copolymer containing a polymer segment including one or both of VP and VC, and a graft copolymer containing a polymer segment including one or both of VP and VC (e.g., a graft copolymer in which polyvinylpyrrolidone is grafted on polyvinyl alcohol). Of them, a vinylpyrrolidon-based polymer (PVP) is preferably exemplified. Here, the vinylpyrrolidone-based polymer refers to a homopolymer of VP or a copolymer of VP (e.g., a copolymer in which the copolymerization proportion of VP exceeds 50% by weight). In the vinylpyrrolidone-based polymer, the proportion of the mole number of a VP unit relative to the mole number of all the repeating units is 50% or more in general, and is appropriately 80% or more (e.g., 90% or more, typically 95% or more) . All the repeating units of the water-soluble polymer may be substantially constituted by VP units.

Specific examples of the N-vinyl chain amide include N-vinyl acetamide, N-vinyl propionic acid amide, and N-vinyl butyric acid amide.

Examples of the imine derivative (hereinafter also referred to as a "water-soluble polymer PD") include homopolymers and copolymers of an N-acyl alkyleneimine type monomer. Specific examples of the N-acyl alkyleneimine type monomer include N-acetylethyleneimine, N-propionylethyleneimine, N-caproylethyleneimine, N-benzoylethyleneimine, N-acetylpropyleneimine, and N-butyrylethyleneimine. As the homopolymer of an N-acyl alkyleneimine type monomer, poly(N-acyl alkyleneimine) can be used, for example. Specific examples include poly(N-acetylethyleneimine), poly(N-propionylethyleneimine), poly(N-caproylethyleneimine), poly(N-benzoylethyleneimine), poly(N-acetylpropyleneimine), and poly(N-butyrylethyleneimine). Examples of the copolymer of an N-acyl alkyleneimine type monomer include a copolymer of two or more types of N-acyl alkyleneimine type monomers and a copolymer of one or more types of N-acyl alkyleneimine type monomers and another monomer.

Examples of the polymer containing an N-(meth)acryloyl type monomer unit (hereinafter also referred to as a "water-soluble polymer PE") include a homopolymer of an N-(meth)acryloyl type monomer and a copolymer of an N-(meth) acryloyl type monomer (typically a copolymer in which a copolymerization proportion of the N-(meth)acryloyl type monomer exceeds 50% by weight). Examples of the N-(meth) acryloyl type monomer include chain amide including an N-(meth)acryloyl group and cyclic amide including an N-(meth)acryloyl group.

Examples of the chain amide including an N-(meth)acryloyl group include acrylamide; N-monoalkyl acrylamides such as N-methylacrylamide, N-ethylacrylamide, N-propylacrylamide, N-isopropylacrylamide, N-butylacrylamide, N-isobutylacrylamide, N-tert-butylacrylamide, N-heptylacrylamide, N-octylacrylamide, N-tert-octylacrylamide, N-dodecylacrylamide, and N-octadecylacrylamide; substituted N-monoalkyl acrylamides such as N-(2-hydroxyethyl)acrylamide, N-(1,1-dimethyl-2-hydroxyethyl)acrylamide, N-(1-ethyl-hydroxyethyl)acrylamide, N-(2-chloroethyl)acrylamide, N-(2,2,2-trichloro-1-hydroxyethyl)acrylamide, N-(2-dimethylaminoethyl)acrylamide, N-(3-dimethylaminopropyl)acrylamide, N-[3-bis(2-hydroxyethyl)aminopropyl]acrylamide, N-(1,1-dimethyl-2-dimethylaminoethyl)acrylamide, N-(2-methyl-2-phenyl-3-dimethylaminopropyl)acrylamide, N-(2,2-dimethyl-3-dimethylaminopropyl)acrylamide, N-(2-morphorinoethyl)acrylamide, and N-(2-amino-1,2-dicyanoethyl)acrylamide; N-monalkenyl acrylamides such as N-allylacrylamide; N-monoalkynyl acrylamides such as N-(1,1-dimethylpropynyl)acrylamide; aromatic group-containing acrylamides such as N-phenylacrylamide, N-benzylacrylamide, and N-[4-(phenylamino)phenyl]acrylamide; N-monoalkylol acrylamides such as N-methylolacrylamide, N-ethylolacrylamide, and N-propylolacrylamide; N-alkoxyalkyl acrylamides such as N-methoxymethylacrylamide, N-ethoxymethylacrylamide, N-butoxymethylacrylamide, and N-isobutoxymethylacrylamide; N-alkoxy acrylamides such as N-methoxyacrylamide, N-ethoxyacrylamide, N-propoxyacrylamide, and N-butoxyacrylamide; N-acetylacrylamide; N-diacetone acrylamide; methacrylamide; N-monoalkyl methacrylamides such as N-methylmethacrylamide, N-ethylmethacrylamide, N-propylmethacrylamide, N-isopropylmethacrylamide, N-butylmethacrylamide, N-isobutylmethacrylamide, N-tert-butylmethacrylamide, N-heptylmethacrylamide, N-octylmethacrylamide, N-tert-octylmethacrylamide, N-dodecylmethacrylamide, and N-octadecylmethacrylamide; substituted N-monoalkyl methacrylamides such as N-(2-hydroxyethyl)methacrylamide, N-(1,1-dimethyl-2-hydroxyethyl)methacrylamide, N-(1-ethyl-hydroxyethyl)methacrylamide, N-(2-chloroethyl)methacrylamide, N-(2,2,2-trichloro-1-hydroxyethyl)methacrylamide, N-(2-dimethylaminoethyl)methacrylamide, N-(3-dimethylaminopropyl)methacrylamide, N-[3-bis(2-hydroxyethyl)aminopropyl]methacrylamide, N-(1,1-dimethyl-2-dimethylaminoethyl)methacrylamide, N-(2-methyl-2-phenyl-3-dimethylaminopropyl)methacrylamide, N-(2,2-dimethyl-3-dimethylaminopropyl)methacrylamide, N-(2-morphorinoethyl)methacrylamide, and N-(2-amino-1,2-dicyanoethyl)methacrylamide; N-monoalkenyl methacrylamides such as N-allylmethacrylamide; N-monoalkynyl methacrylamides such as N-(1,1-dimethylpropynyl)methacrylamide; aromatic group-containing methacrylamides such as N-phenylmethacrylamide, N-benzylmethacrylamide, and N-[4-(phenylamino)phenyl]methacrylamide; N-monoalkylol methacrylamides such as N-methylolmethacrylamide, N-ethylolmethacrylamide, and N-propylolmethacrylamide; N-alkoxyalkyl methacrylamides such as N-methoxymethylmethacrylamide, N-ethoxymethylmethacrylamide, N-butoxymethylmethacrylamide, and N-isobutoxymethylmethacrylamide; N-alkoxy methacrylamides such as N-methoxymethacrylamide, N-ethoxymethacrylamide, N-propoxymethacrylamide, and N-butoxymethacrylamide; N-acetylmethacrylamide; N-diacetone methacrylamide; N,N-dialkyl acrylamides such as N,N-dimethylacrylamide, N,N-diethylacrylamide, N,N-dipropylacrylamide, N,N-diisopropylacrylamide, N,N-dibutylacrylamide, N,N-diisobutylacrylamide, N,N-di-tert-butylacrylamide, N,N-diheptylacrylamide, N,N-dioctylacrylamide, N,N-di-tert-octylacrylamide, N,N-didodecylacrylamide, and N,N-dioctadecylacrylamide; N,N-dialkylaminoalkylacrylamide such as N,N-dimethylaminoethylacrylamide, N,N-diethylaminoethylacrylamide, N,N-dimethylaminopropylacrylamide, and N,N-diethylaminopropylacrylamide; substituted N,N-dialkyl acrylamides such as N,N-bis(2-hydroxyethyl)acrylamide and N,N-bis(2-cyanoethyl)acrylamide; N,N-dialkenyl acrylamides such as N,N-diallylacrylamide; aromatic group-containing acrylamides such as N,N-diphenylacrylamide and N,N-dibenzylacrylamide; N,N-dialkylol acrylamides such as N,N-dimethylolacrylamide, N,N-diethylolacrylamide, and N,N-dipropylolacrylamide; N-alkoxy-N-alkylacrylamides such as N-methyl-N-methoxyacrylamide, N-methyl-N-ethoxyacrylamide, N-methyl-N-propoxyacrylamide, N-methyl-N-butoxyacrylamide, N-ethyl-N-methoxyacrylamide, N-ethyl-N-ethoxyacrylamide, N-ethyl-N-butoxyacrylamide, N-propyl-N-methoxyacrylamide, N-propyl-N-ethoxyacrylamide, N-butyl-N-methoxyacrylamide, and N-butyl-N-ethoxyacrylamide; N,N-diacetylacrylamide; N,N-diacetone acrylamide; N,N-dialkylmethacrylamides such as N,N-dimethylmethacrylamide, N,N-diethylmethacrylamide, N,N-dipropylmethacrylamide, N,N-diisopropylmethacrylamide, N,N-dibutylmethacrylamide, N,N-diisobutylmethacrylamide, N,N-di-tert-butylmethacrylamide, N,N-diheptylmethacrylamide, N,N-dioctylmethacrylamide, N,N-di-tert-octylmethacrylamide, N,N-didodecylmethacrylamide, and N,N-dioctadecylmethacrylamide; N,N-dialkylaminoalkylmethacrylamides such as N,N-dimethylaminoethylmethacrylamide, N,N-diethylaminoethylmethacrylamide, N,N-dimethylaminopropylmethacrylamide, and N,N-diethylaminopropylmethacrylamide; substituted N,N-dialkylmethacrylamides such as N,N-bis(2-hydroxyethyl)methacrylamide and N,N-bis(2-cyanoethyl)methacrylamide; N-dialkenylmethacrylamides such as N,N-diallylmethacrylamide; aromatic group-containing methacrylamides such as N,N-diphenylmethacrylamide and N,N-dibenzylmethacrylamide; N,N-dialkylol methacrylamides such as N,N-dimethylolmethacrylamide, N,N-diethylolmethacrylamide, and N,N-dipropylolmethacrylamide; N-alkoxy -N-alkylmethacrylamides such as N-methyl-N-methoxymethacrylamide, N-methyl-N-ethoxymethacrylamide, N-methyl-N-propoxymethacrylamide, N-methyl-N-butoxymethacrylamide, N-ethyl-N-methoxymethacrylamide, N-ethyl-N-ethoxymethacrylamide, N-ethyl-N-butoxymethacrylamide, N-propyl-N-methoxymethacrylamide, N-propyl-N-ethoxymethacrylamide, N-butyl-N-methoxymethacrylamide, and N-butyl-N-ethoxymethacrylamide; N,N-diacetylmethacrylamide; and N,N-diacetone methacrylamide.

Examples of the polymer including chain amide having an N-(meth)acryloyl group as a monomer unit include a homopolymer of N-isopropylacrylamide and a copolymer of N-isopropylacrylamide (e.g., a copolymer in which a copolymerization proportion of N-isopropylacrylamide exceeds 50% by weight).

Examples of the cyclic amide having an N- (meth) acryloyl group include N-acryloylmorpholine, N-acryloylthiomorpholine, N-acryloylpiperidine, N-acryloylpyrrolidine, N-methacryloyl morpholine, N-methacryloyl piperidine, and N-methacryloyl pyrrolidine. Examples of the polymer including cyclic amide having an N-(meth)acryloyl group as a monomer unit include an acryloylmorpholine polymer (PACMO) . Typical examples of the acryloylmorpholine polymer include a homopolymer of N-acryloylmorpholine (ACMO) and a copolymer of ACMO (e.g., a copolymer in which a copolymerization proportion of ACMO exceeds 50% by weight). In the acryloylmorpholine polymer, the proportion of the mole number of an ACMO unit relative to the mole number of all the repeating units is 50% or more in general, and is appropriately 80% or more (e.g., 90% or more, typically 95% or more) . All the repeating units of the water-soluble polymer may be substantially constituted by ACMO units.

The vinyl alcohol polymer (hereinafter also referred to as a "water-soluble polymer PF") is typically a polymer containing a vinyl alcohol unit (VA unit) as a main repeating unit (PVA). In this polymer, the proportion of the mole number relative to the mole number of all the repeating units is 50% or more in general, preferably 65% or more, more preferably 70% or more, and for example, 75% or more. All the repeating units may be substantially constituted by VA units. In the water-soluble polymer PF, the types of repeating units except VA units are not limited to particular types, and can be exemplified by, for example, a vinyl acetate unit, a vinyl propionate unit, and a vinyl hexanoate unit.

The PVA has a saponification degree of 50% by mole or more in general, preferably 65% by mole or more, more preferably 70% by mole or more, and for example, 75% by mole or more. The saponification degree of the PVA is 100% by mole or less in principle.

Although not critical, the polishing slurry disclosed here can be preferably provided in such an embodiment that the polishing slurry contains, as a water-soluble polymer, at least a water-soluble polymer PA and/or a water-soluble polymer PF. In a preferred embodiment, the polishing slurry contains at least a water-soluble polymer PA (typically HEC) as a water-soluble polymer. For example, an embodiment in which the water-soluble polymer PA is included singly, an embodiment in which the water-soluble polymer PA and the water-soluble polymer PC are included, and an embodiment in which the water-soluble polymer PA and the water-soluble polymer PE are included, can be employed. Preferred examples of such a polishing slurry include a polishing slurry in which a main component (typically, a component occupying more than 50% by weight in the water-soluble polymer) of the water-soluble polymer is HEC. In addition, 60% by weight or more, for example, 80% by weight or more, more preferably 90% by weight or more of a water-soluble polymer may be HEC, and 100% by weight of the water-soluble polymer may be HEC. In a preferred embodiment, at least the water-soluble polymer PF is included as the water-soluble polymer. For example, an embodiment in which the water-soluble polymer PF is included singly, an embodiment in which the water-soluble polymer PF and the water-soluble polymer PC are included, and an embodiment in which the water-soluble polymer PF and the water-soluble polymer PA are included, can be employed.

In each polishing slurry disclosed here, the Mw of the water-soluble polymer is not limited to particular values. From the viewpoints of, for example, filterability and cleanability, a water-soluble polymer having an Mw of, for example, 200 × 10⁴ or less, preferably 150 × 10⁴ or less, and more preferably 100 × 10⁴ or less can be used. In general, there is a tendency in which as the Mw of the water-soluble polymer increases, the mole number in the same load decreases so that the polishing rate increases. In view of this, a water-soluble polymer having an Mw of 0.1 × 10⁴ or more is appropriately used in general, and a water-soluble polymer having an Mw of 1 × 10⁴ or more is preferably employed, for example.

A more preferred range of the Mw can also differ depending on the type of the water-soluble polymer. For example, the Mw of the water-soluble polymer PA is typically less than 100 × 10⁴, preferably 80 × 10⁴ or less, more preferably 75 × 10⁴ or less, and even more preferably 60 × 10⁴ or less (typically 30 × 10⁴ or less). The Mw of the water-soluble polymer PA is typically 1 × 10⁴ or more, preferably 2 × 10⁴ or more, more preferably 3 × 10⁴ or more, and even more preferably 5 × 10⁴ or more (e.g., 7 × 10⁴ or more) . For example, the Mw of the water-soluble polymer PB is preferably 20 × 10⁴ or less, preferably 10 × 10⁴ or less, and even more preferably 5 × 10⁴ or less. The Mw of the water-soluble polymer PB is typically 1 × 10⁴ or more. For example, the Mw of the water-soluble polymer PC is typically 15 × 10⁴ or less, preferably 10 × 10⁴ or less, and more preferably 8 × 10⁴ or less (e.g., 5 × 10⁴ or less). The Mw of the water-soluble polymer PC is typically 1 × 10⁴ or more. For example, the Mw of the water-soluble polymer PD is preferably 30 × 10⁴ or less, more preferably 20 × 10⁴ or less, and even more preferably 10 × 10⁴ or less (e.g., 5 × 10⁴ or less). The Mw of the water-soluble polymer PD is typically 1 × 10⁴ or more. For example, the Mw of the water-soluble polymer PE is typically 60 × 10⁴ or less, preferably 50 × 10⁴ or less, and more preferably 40 × 10⁴ or less. The Mw of the water-soluble polymer PE is typically 1 × 10⁴ or more. For example, the Mw of the water-soluble polymer PF is typically 6 × 10⁴ or less, preferably 4 × 10⁴ or less, and more preferably 3 × 10⁴ or less (e.g., 2 × 10⁴ or less) . The Mw of the water-soluble polymer PF is typically 1 × 10³ or more, preferably 3 × 10³ or more, and for example, 4 × 10³ or more. A water-soluble polymer PF having an Mw of 1 × 10⁴ or more may be used.

In the technique disclosed here, a relation between the weight average molecular weight (Mw) and the number average molecular weight (Mn) of the water-soluble polymer is not limited to particular values. For example, a water-soluble polymer in which a relation between the Mw and the Mn satisfies Mw/Mn ≤ 5.0 can be preferably used. From the viewpoint of, for example, performance stability of the polishing slurry, Mw/Mn of the water-soluble polymer is preferably 4.8 or less and more preferably 4.6 or less. In principle, Mw/Mn is 1.0 or more. As the Mw and the Mn of the water-soluble polymer, values determined by gel permeation chromatography (GPC) (aqueous system, in terms of polyethylene oxide) can be adopted.

A more preferred range of Mw/Mn can also vary depending on the type of the water-soluble polymer. For example, Mw/Mn of the water-soluble polymer PA is preferably 4.8 or less and more preferably 4.6 or less. For example, Mw/Mn of the water-soluble polymer PB is preferably 4.0 or less, more preferably 3.5 or less, and even more preferably 3.0 or less . For example, Mw/Mn of the water-soluble polymer PC is preferably 4.0 or less, more preferably 3.5 or less, and even more preferably 3.0 or less. For example, Mw/Mn of the water-soluble polymer PD is preferably 4.0 or less, more preferably 3.5 or less, and even more preferably 3.0 or less . For example, Mw/Mn of the water-soluble polymer PE is preferably 4.0 or less, more preferably 3.5 or less, and even more preferably 3.0 or less. For example, Mw/Mn of the water-soluble polymer PF is preferably 4.0 or less, more preferably 3.5 or less, and even more preferably 3.0 or less .

On the other hand, for example, Mw/Mn of the water-soluble polymer PA is preferably 2.0 or more and more preferably 3.0 or more. For example, Mw/Mn of each of the water-soluble polymer PB, the water-soluble polymer PC, the water-soluble polymer PD, the water-soluble polymer PE, and the water-soluble polymer PF is preferably 1.05 or more.

Although not critical, in a case where the intermediate polishing slurry Sp contains a water-soluble polymer, the Mw of the water-soluble polymer is 60 × 10⁴ or less, and even more preferably 30 × 10⁴ or less in general, from the viewpoint of sufficiently obtaining both a polishing rate in the intermediate polishing step and a surface grade after the final polishing step. In a preferred embodiment, the intermediate polishing slurry Sp can contain a water-soluble polymer having an Mw of 60 × 10⁴ or less (more preferably an Mw of 30 × 10⁴ or less) singly or in combination with a water-soluble polymer having a higher Mw. The water-soluble polymer preferably has an Mw of 1 × 10⁴ or more. The upper and lower limits of the Mw of such a water-soluble polymer are applicable to a preferred Mw of a water-soluble polymer that is contained in the final polishing slurry Sf. The technique disclosed here can be performed in an embodiment in which each of the intermediate polishing slurry Sp and the final polishing slurry Sf contains a water-soluble polymer.

Although not critical, in a case where one of polishing slurries disclosed here contains a water-soluble polymer, the content of the water-soluble polymer is, for example, 0.001 parts by weight relative to 100 parts by weight of abrasive grains. From the viewpoint of enhancement of surface smoothness (e.g., reduction of haze or defects) after polishing, the content of the water-soluble polymer relative to 100 parts by weight of abrasive grains is appropriately 0.05 parts by weight or more, preferably 0.1 part by weight or more, and more preferably 0.5 parts by weight or more (e.g., 1 part by weight or more) . From the viewpoints of, for example, the polishing rate and cleanability, the content of the water-soluble polymer relative to 100 parts by weight of abrasive grains can be, for example, 300 parts by weight or less, is appropriately 20 parts by weight or less in general, preferably 15 parts by weight or less, and more preferably 10 parts by weight or less.

In a case where the intermediate polishing slurry Sp contains a water-soluble polymer, the content of the water-soluble polymer is not limited to particular values, and may be 1 × 10⁻⁴% by weight or more, for example. From the viewpoint of surface grade after the subsequent final polishing step, the content is preferably 5×10⁻⁴% by weight or more and more preferably 1 × 10⁻³% by weight or more. From the viewpoint of polishing efficiency, the content is preferably 0.5% by weight or less and more preferably 0.1% by weight or less (e.g., 0.05% by weight or less).

In a case where the final polishing slurry Sf contains a water-soluble polymer, the content of the water-soluble polymer is not limited to particular values, and can be, for example, 1 × 10⁻⁴% by weight or more. From the viewpoint of surface grade after the final polishing step, the content is preferably 5 × 10⁻⁴% by weight or more and more preferably 1 × 10⁻³% by weight or more. From the viewpoint of polishing efficiency, the content is preferably 0.5% by weight or less and more preferably 0.25% by weight or less (e.g., 0.1% by weight or less) .

### <Surfactant>

The polishing slurry Sf contains a surfactant, but also the polishing slurry Sp may contain a surfactant (typically a water-soluble organic compound with a molecular weight of less than 1 × 10⁴) as needed. The use of the surfactant can enhance surface grade after polishing. In addition, dispersion stability of the polishing slurry can be enhanced. Surfactants can be used singly or in combination of two or more of them.

As the surfactant, an anionic surfactant or a nonionic surfactant can be preferably adopted. From the viewpoints of low foaming properties and easy adjustment of pH, a nonionic surfactant is more preferred. Nonionic surfactants including oxyalkylene polymers such as polyethylene glycol, polypropylene glycol, and polytetramethylene glycol; polyoxyalkylene adducts such as polyoxyethylene alkyl ethers, polyoxyethylene alkyl phenyl ethers, polyoxyethylene alkylamines, polyoxyethylene fatty acid esters, polyoxyethylene glyceryl ether fatty acid esters, and polyoxyethylene sorbitan fatty acid esters; and copolymers (diblock copolymers, triblock copolymers, random copolymers, alternating copolymers) of a plurality types of oxyalkylenes are exemplified.

Specific examples of the nonionic surfactant include block copolymers of EO and PO (e.g., diblock copolymers, PEO-PPO-PEO-type triblock copolymers, PPO-PEO-PPO-type triblock copolymers), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octylphenyl ether, polyoxyethylene nonylphenyl ether, polyoxyethylene dodecyl phenyl ether, polyoxyethylene styrenated phenyl ether, polyoxyethylene laurylamine, polyoxyethylene stearylamine, polyoxyethylene oleylamine, polyoxyethylene stearylamide, polyoxyethylene oleylamide, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbitol tetraoleate, polyoxyethylene castor oil, and polyoxyethylene hydrogenated castor oil. As preferred surfactants of them, block copolymers of EO and PO (especially, PEO-PPO-PEO-type triblock copolymers), random copolymers of EO and PO, and polyoxyethylene alkyl ethers (e.g., polyoxyethylene decyl ether) are exemplified.

The molecular weight of the surfactant is typically less than 1 × 10⁴ and is, from the viewpoints of, for example, filterability of the polishing slurry and cleanability of an object to be polished, preferably 9,500 or less. The molecular weight of the surfactant is typically 200 or more and is, from the viewpoint of, for example, an increase of the polishing rate, preferably 250 or more and more preferably 300 or more. As the molecular weight (Mw) of the surfactant, a weight average molecular weight determined by GPC (aqueous system, in terms of polyethylene glycol) or a molecular weight calculated from the chemical formula can be adopted.

A more preferred range of the molecular weight of the surfactant can also vary depending on the type of the surfactant. For example, in the case of using a block copolymer of EO and PO as the surfactant, the block copolymer has an Mw of preferably 1000 or more, more preferably 2000 or more, and even more preferably 5000 or more.

In a case where the polishing slurry disclosed here contains the surfactant, the content of the surfactant is not limited to particular values as long as advantages of the present invention are not significantly impaired. In general, from the viewpoint of, for example, cleanability, the content of the surfactant relative to 100 parts by weight of abrasive grains is appropriately 20 parts by weight or less, preferably 15 parts by weight or less, and more preferably 10 parts by weight or less (e.g., 6 parts by weight or less) . From the viewpoint of exerting higher effects of the surfactant, the content of the surfactant relative to 100 parts by weight of abrasive grains is appropriately 0.001 part by weight, preferably 0.005 parts by weight or more, and more preferably 0.01 part by weight or more (e.g., 0.05 parts by weight or more, typically 0.1 part by weight or more).

The technique disclosed here can be preferably provided in such a form that the surfactant is contained in the final polishing slurry Sf and no surfactant is contained in the intermediate polishing slurry Sp. The polishing slurry Sf and the polishing slurry Sp having such compositions are preferable because the preferred Hp/Hf ratio disclosed here is likely to be satisfied.

### <Other Components>

Each polishing slurry disclosed here may further contain known additives usable in polishing slurries (typically, polishing slurries used for polishing of a silicon wafer), such as a chelating agent, an organic acid, an organic acid salt, an inorganic acid, an inorganic acid salt, an antiseptic agent, and a fungicide, as necessary, to such an extent as not to markedly suppress effects of the invention.

Examples of the chelating agent include aminocarboxylic acid chelating agents and organic phosphonic acid chelating agents. Examples of the aminocarboxylic acid chelating agent include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraminehexaacetic acid, and sodium triethylenetetraminehexaacetate. Examples of the organic phosphonic acid chelating agent include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid. Of them, organic phosphonic acid chelating agents are more preferred, and ethylenediaminetetrakis(methylenephosphonic acid) and diethylenetriaminepenta(methylenephosphonic acid) are even more preferred. As a particularly preferred chelating agent, diethylenetriaminepenta(methylenephosphonic acid) is exemplified.

Examples of the organic acid include fatty acids such as formic acid, acetic acid, and propionic acid; aromatic carboxylic acids such as benzoic acid and phthalic acid; citric acid; oxalic acid; tartaric acid; malic acid; maleic acid; fumaric acid; succinic acid; organic sulfonic acids; and organic phosphonic acids. Examples of the organic acid salt include alkali metal salts (including sodium salts and potassium salts) of organic acids and ammonium salts of organic acids. Examples of the inorganic acid include sulfuric acid, nitric acid, hydrochloric acid, and carbonic acid. Examples of the inorganic acid salt include alkali metal salts (including sodium salts and potassium salts) of inorganic acids and ammonium salts of inorganic acids. The organic acids and salts thereof and the inorganic acids and salts thereof can be used singly or in combination of two or more of them.

Examples of the antiseptic agent and the fungicide include isothiazoline compounds, p-hydroxybenzoate esters, and phenoxyethanol.

### <Polishing Composition>

Each polishing slurry disclosed here is supplied as a working slurry to a silicon wafer that is an object to be polished and is used for polishing of the silicon wafer. The polishing slurry can be prepared by diluting (typically with water) a polishing composition that is typically a concentrated liquid of the polishing slurry. Alternatively, the polishing composition may be used without any treatment as the polishing liquid. That is, the concept of the polishing composition in the technique disclosed here encompasses both a polishing slurry that is supplied to a silicon wafer and is used for polishing the silicon wafer (working slurry) and a concentrated liquid that is diluted and used as a slurry (a stock solution of a polishing liquid) . Other examples of the polishing slurry containing the polishing composition disclosed here include a polishing slurry prepared by adjusting the pH of the polishing composition.

### <Preparation of Polishing Composition>

The method for producing a polishing composition disclosed here is not limited to particular methods. For example, a well-known mixer such as a blade-type stirrer, an ultrasonic disperser, or a homomixer is used to mix components contained in the polishing composition. The manner of mixing these components is not limited to particular manners. For example, all the components may be concurrently mixed, or the components may be mixed in an appropriate order.

### <Polishing>

The polishing composition disclosed here can be preferably used for polishing a silicon wafer in such a manner as to include the following operations, for example. A preferred embodiment of the method for polishing an object to be polished by using the polishing composition disclosed here will next be described.

That is, a polishing slurry containing any of the polishing compositions disclosed here is prepared. The preparing a polishing slurry can include preparing a polishing slurry by subjecting a polishing composition to concentration adjustment (e.g., dilution), pH adjustment, and other operations. Alternatively, the polishing composition may be used as the polishing slurry without any treatment.

Next, the polishing slurry is supplied to a silicon wafer that is an object to be polished, and the silicon wafer is polished in usual ways. For example, in the case of performing primary polishing on the silicon wafer, a silicon wafer that has been subjected to a lapping step is set to a common polishing apparatus, and a polishing slurry is supplied to a surface to be polished of the silicon wafer through a polishing pad of the polishing apparatus. Typically, while the polishing slurry is continuously supplied, the polishing pad is pressed against the surface to be polished of the silicon wafer, and the polishing pad and the silicon wafer are relatively moved (e.g., rotationally moved). Through the polishing step, the polishing of the silicon wafer is completed.

The polishing pad used in the polishing step using the polishing slurry containing the polishing composition disclosed here may be any polishing pad. For example, any of nonwoven fabric polishing pads, suede polishing pads, polishing pads containing abrasive grains, and polishing pads containing no abrasive grains may be used.

### <Cleaning>

An object polished using the polishing slurry disclosed here is typically cleaned after polishing. This cleaning can be performed by using an appropriate cleaning solution. The cleaning solution used may be any cleaning solution. For example, an SC-1 cleaning solution (a mixed solution of ammonium hydroxide (NH₄OH), hydrogen peroxide (H₂O₂), and water (H₂O); hereinafter, cleaning with the SC-1 cleaning solution will be referred to as "SC-1 cleaning") or an SC-2 cleaning solution (a mixed solution of HCl, H₂O₂, and H₂O), which are commonly used in the field of semiconductors and the like, can be used. The temperature of the cleaning solution is room temperature or higher and about 90°C or lower, for example. From the viewpoint of improving cleaning efficiency, a cleaning solution at about 50°C or more and 85°C or less can be preferably used.

### <Concentrated Liquid of Polishing Slurry>

Each polishing slurry disclosed here may be in a concentrated form (i.e., the form of a concentrated liquid of the polishing slurry) before supplied to a silicon wafer that is an object to be polished. The polishing slurry in such a concentrated liquid form has advantages from the viewpoint of convenience at the time of production, distribution, storage, and the like and cost reduction, for example.

The polishing slurry in such a concentrated liquid form can be used in such a manner that a polishing slurry (working slurry) is prepared by diluting the polishing slurry at an appropriate timing and is supplied to a polishing object. This dilution can be typically performed by adding the above-mentioned aqueous solvent to the concentrated liquid and mixing these materials. In a case where the aqueous solvent is a mixed solvent, some of the components in the aqueous solvent may be added for dilution, or a mixed solvent containing these components at a ratio different from that of the aqueous solvent may be added for dilution.

For example, the NV of the concentrated liquid can be 50% by mass or less. From the viewpoints of, for example, stability of the polishing composition (e.g., dispersion stability of abrasive grains) and filterability, the NV of the concentrated liquid is preferably 40% by weight or less in general. From the viewpoints of, for example, convenience at the time of production, distribution, storage, and the like, and cost reduction, the NV of the concentrated liquid is appropriately 0.5% by weight or more, preferably 1% by weight or more, more preferably 3% by weight or more, and for example, 5% by weight or more.

The polishing composition disclosed here may be a one-pack type or a multi-component type including a two-pack type. For example, the polishing composition can be composed in such a manner that a liquid X containing some of the components of the polishing composition (typically a composition except the aqueous solvent) is mixed with a liquid Y containing the remaining components, and the mixture is used for polishing a silicon wafer. The technique disclosed here can be preferably performed in the form of a one-pack type, for example.

### <Application>

The technique disclosed here can provide a silicon wafer having a high-quality surface (e.g., a surface with a reduced number of light point defect non-cleanable (LPD-N) or polishing induced defects (PIDs)). Thus, the polishing method disclosed here can be preferably performed for polishing a silicon wafer.

### <Polishing Composition Set>

The technique disclosed here can include, for example, provision of a polishing composition set as follows. Specifically, the technique disclosed here can provide a polishing composition set including a polishing composition A and a polishing composition B that are separately stored. The polishing composition A can be the polishing slurry Sp that is used in the intermediate polishing step or a concentrated liquid of the polishing slurry Sp. The polishing composition B can be the polishing slurry Sf that is used in the final polishing step or a concentrated liquid of the polishing slurry Sf.

The polishing composition set can reduce occurrence of a mismatch between the surface quality (typically, surface smoothness) of a silicon wafer and processing power (typically, polishing power) of the polishing slurry in a multi-stage polishing process steps that are sequentially performed, and thereby, can effectively enhance the surface quality. Thus, the polishing composition set can provide a high-grade silicon wafer having high surface smoothness and a reduced number of defects. The polishing composition set can contribute to reduction of the polishing time and enhancement of working efficiency.

Some examples relating to the present invention will next be described, but the present invention is not intended to be limited to these examples. In the following description, "part, " "%," and "ppm" are in terms of weight unless otherwise specified.

### <Preparation of Polishing Slurry>

### (Polishing Slurry A)

Abrasive grains, aqueous ammonia (concentration: 29%), hydroxyethyl cellulose (HEC), and deionized water were mixed to obtain a concentrated liquid (polishing composition) of a polishing slurry. This concentrated liquid was diluted with deionized water 40 times to prepare a polishing slurry A.

As the abrasive grain, colloidal silica having an average primary particle size (D₁ₓ) of 35 nm and an average secondary particle size (D_{Vx}) of 66 nm was used. The average primary particle size was determined by using a surface area analyzer, trade name "Flow Sorb II 2300, " manufactured by Micromeritics . The average secondary particle size was a volume average particle size (Mv) determined by using a model "UPA-UT151" manufactured by NIKKISO CO., LTD. based on dynamic light scattering.

As HEC, HEC having an Mw of 25 × 10⁴ was used.

The amounts of abrasive grains, aqueous ammonia, and HEC were such that the content of abrasive grains in the polishing slurry A was 0.23%, the content of ammonia (NH₃) derived from the aqueous ammonia was 0.012%, and the content of HEC was 0.004%.

### (Polishing Slurry B)

A polishing slurry B was prepared in the same manner as that of the polishing slurry A except that the content of HEC was changed to 0.002%.

### (Polishing Slurry C)

A polishing slurry C was prepared in the same manner as that of the polishing slurry A except that HEC having an Mw of 50 × 10⁴ was used as a water-soluble polymer.

### (Polishing Slurry D)

In preparing the polishing slurry A, the amount of aqueous ammonia was changed so that the content of ammonia (NH₃) was 0.016%, and two types of water-soluble polymers: HEC having an Mw of 25 × 10⁴ and poly-N-vinylpyrrolidone (PVP) having an Mw of 4.5 × 10⁴ were used. In the other respects, the manner in preparing a polishing slurry D was the same as that in preparing the polishing slurry A. Regarding the amount of HEC, the content of HEC in the polishing slurry D was 0.002%. Regarding the amount of PVP, the content of PVP in the polishing slurry D was 0.001%.

### (Polishing Slurry E)

A polishing slurry E was prepared in the same manner as that of the polishing slurry A except that the amount of aqueous ammonia was changed so that the content of ammonia (NH₃) was 0.016% and HEC having an Mw of 100 × 10⁴ was used as a water-soluble polymer to have a content of 0.003%.

### (Polishing Slurry F)

A polishing slurry F was prepared in the same manner as that of the polishing slurry A except that HEC having an Mw of 120 × 10⁴ was used as a water-soluble polymer.

### (Polishing Slurry G)

As a polishing slurry G, the standard slurry I described above was used.

### (Polishing Slurry H)

As a polishing slurry H, the standard slurry II described above was used.

### (Polishing Slurry I)

Abrasive grains, aqueous ammonia (concentration: 29%), HEC (Mw: 25 × 10⁴), a PEO-PPO-PEO block copolymer (hereinafter referred to as a "PEO-PPO-PEO"), polyoxyethylene alkyl ether (hereinafter referred to as "PEO-alkyl ether"), and deionized water were mixed to obtain a concentrated liquid (polishing composition) of a polishing slurry. This concentrated liquid was diluted with deionized water 20 times to prepare a polishing slurry I.

As the abrasive grain, colloidal silica having an average primary particle size (D₁ₓ) of 25 nm and an average secondary particle size (D_{Vx}) of 46 nm was used.

As the PEO-PPO-PEO, a copolymer having an Mw of 9000 and a weight ratio of EO:PO of 80:20 was used in the same manner as the standard slurry II.

As the PEO-alkyl ether, polyoxyethylene decyl ether (molecular weight: 400) was used.

Regarding the amounts of abrasive grain, aqueous ammonia, HEC, PEO-PPO-PEO, and PEO-alkyl ether, the contents of these materials in the polishing slurry I were those indicated in Table 1.

### (Polishing Slurry J)

Abrasive grains, aqueous ammonia (concentration: 29%), HEC (Mw: 25 × 10⁴), PVP (Mw: 4.5 × 10⁴), PEO-alkyl ether, and deionized water were mixed to obtain a concentrated liquid (polishing composition) of a polishing slurry. This concentrated liquid was diluted with deionized water 40 times to prepare a polishing slurry J. As the abrasive grains and the PEO-alkyl ether, the same abrasive grains and PEO-alkyl ether as those used in preparing the polishing slurry I were used.

Regarding the amounts of abrasive grain, aqueous ammonia, HEC, PVP, and PEO-alkyl ether, the contents of these materials in the polishing slurry J were those indicated in Table 1.

General compositions of the polishing slurries A to J are indicated in Table 1 together with general compositions of the standard slurries I and II and the rinse solution.

**[Table 1]**

| | Abrasive grains | | Alkali | | Water-soluble polymer | | | Surfactant | |
|---|---|---|---|---|---|---|---|---|---|
| | D₁ₓ [nm] | Content [wt%] | Type | Content [wt%] | Type | Mw [×10⁴] | Content [wt%] | Type | Content [wt%] |
| Standard I | 35 | 0.95 | KOH | 0.065 | - | - | - | - | - |
| Standard II | 35 | 0.46 | NH₃ | 0.009 | HEC | 25 | 0.017 | PEO-PPO-PEO | 0.002 |
| Rinse solution | - | - | NH₃ | 0.0005 | HEC | 25 | 0.013 | - | - |
| A | 35 | 0.23 | NH₃ | 0.012 | HEC | 25 | 0.004 | - | - |
| B | 35 | 0.23 | NH₃ | 0.012 | HEC | 25 | 0.002 | - | - |
| C | 35 | 0.23 | NH₃ | 0.012 | HEC | 50 | 0.004 | - | - |
| D | 35 | 0.23 | NH₃ | 0.016 | HEC | 25 | 0.002 | - | - |
| | | | | | PVP | 4.5 | 0.001 | | |
| E | 35 | 0.23 | NH₃ | 0.016 | HEC | 100 | 0.003 | - | - |
| F | 35 | 0.23 | NH₃ | 0.012 | HEC | 120 | 0.004 | - | - |
| G | 35 | 0.95 | KOH | 0.065 | - | - | - | - | - |
| H | 35 | 0.46 | NH₃ | 0.009 | HEC | 25 | 0.017 | PEO-PPO-PEO | 0.002 |
| I | 25 | 0.18 | NH₃ | 0.005 | HEC | 25 | 0.009 | PEO-PPO-PEO | 0.001 |
| | | | | | | | | PEO-alkyl ether | 0.0001 |
| J | 25 | 0.08 | NH₃ | 0.006 | HEC | 25 | 0.004 | PEO-alkyl ether | 0.0005 |
| | | | | | PVP | 4.5 | 0.003 | | |

### <Measurement of Relative Haze>

Relative hazes of the polishing slurries A to J were measured in accordance with the above-described relative haze measuring method.

Specifically, a commercially available polished silicon wafer was polished using the standard slurry I as a polishing slurry under the conditions 1 described above, rinsed with a rinse solution, and then polished using the standard slurry II as a polishing slurry under conditions 2 described above (pretreatment X) . More specifically, as the conditions 1 and the conditions 2 in the pretreatment X, conditions 1A and conditions 2A described below were respectively employed. As the silicon wafer, a P-type silicon wafer having a diameter of 300 mm, a crystal orientation of <100>, and a resistivity of 0.1 Ω·cm or more and less than 100 Ω·cm was used.

### [Conditions 1A]

Polishing apparatus: a single wafer polishing machine, model "PNX-332B" manufactured by Okamoto Machine Tool Works, Ltd. Polishing table: a first table was used among three tables of the polishing apparatus.
Polishing pad: a polishing pad, trade name "FP55" (nonwoven fabric type, thickness: about 2 mm, density: about 0.3 g/cm3, compression ratio: about 7%, compression modulus of elasticity: about 90%, and hardness: about 50°) manufactured by Fujibo Ehime Co., Ltd.
Polishing load: 20 kPa
Rotation rate of surface plate: 20 rpm
Rotation rate of head: 20 rpm
Temperature of surface plate cooling water: 20°C
Temperature of polishing slurry: 20°C
Supply rate of polishing slurry: 1.0 liter/min (free-flowing) Polishing time: 3 minutes

### [Conditions 2A]

Polishing apparatus: a single wafer polishing machine, model "PNX-332B" manufactured by Okamoto Machine Tool Works, Ltd. Polishing table: a second table was used among three tables of the polishing apparatus.

Polishing pad: a polishing pad, trade name "POLYPAS27NX" (suede type, thickness: about 1.5 mm, density: about 0.4 g/cm3, compression ratio: about 20%, compression modulus of elasticity: about 90%, hardness: about 40°, average opening diameter: about 45 um, and opening ratio: about 25%) manufactured by Fujibo Ehime Co., Ltd.
Polishing load: 15 kPa
Rotation rate of surface plate: 30 rpm
Rotation rate of head: 30 rpm
Temperature of surface plate cooling water: 20°C
Temperature of polishing slurry: 20°C
Supply rate of polishing slurry: 2.0 liter/min (free-flowing)
Polishing time: 3 minutes

After the pretreatment X, SC-1 cleaning and isopropyl alcohol (IPA) vapor drying described later were performed, and thereafter, a haze reference value h₀ was measured. More specifically, the haze reference value h₀ was measured by using a wafer inspection apparatus, trade name "Surfscan SP2" manufactured by KLA-Tencor in a DWO mode.

The obtained polishing object subjected to the pretreatment X was polished by using a polishing slurry Sx under the conditions 2 described above. More specifically, in the polishing using the polishing slurry Sx, conditions 2B described below were employed as the conditions 2. Thereafter, SC-1 cleaning and IPA vapor drying were performed, and subsequently, a haze measured value hx was measured. More specifically, the haze measured value hx was measured by using a wafer inspection apparatus, trade name "Surfscan SP2" manufactured by KLA-Tencor in a DWO mode.

### [Conditions 2B]

Polishing apparatus: a single wafer polishing machine, model "PNX-332B" manufactured by Okamoto Machine Tool Works, Ltd. Polishing table: a third table was used among three tables of the polishing apparatus.
Polishing pad: a polishing pad, trade name "POLYPAS27NX" manufactured by Fujibo Ehime Co., Ltd.
Polishing load: 15 kPa
Rotation rate of surface plate: 30 rpm
Rotation rate of head: 30 rpm
Temperature of surface plate cooling water: 20°C
Temperature of polishing slurry: 20°C
Supply rate of polishing slurry: 2.0 liter/min (free-flowing)
Polishing time: 3 minutes

### [SC-1 cleaning]

A silicon wafer after polishing was cleaned with a cleaning solution having a composition in which of aqueous ammonia (concentration: 29%) : hydrogen peroxide (concentration: 31%) : deionized water (DIW) = 1 : 3 : 30 (volume ratio). More specifically, two cleaning baths each equipped with an ultrasonic oscillator at a frequency of 950 kHz were prepared, and the cleaning solution was placed in each of the first and second cleaning baths and kept at 60°C. Next, a silicon wafer after polishing was immersed in the cleaning solution in the first cleaning bath for 6 minutes while the ultrasonic oscillator was activated, then was immersed and rinsed in ultrapure water in a rinse bath while an ultrasonic oscillator was activated, and was further immersed in the cleaning solution in the second cleaning bath for 6 minutes while the ultrasonic oscillator was activated.

Table 2 indicates the results. Table 2 also indicates Hp/Hf values in examples and comparative examples.

### <Measurement of Polishing Rate Index>

Polishing rate indexes of the polishing slurries A to J were measured in accordance with the polishing rate index measuring method described above.

Specifically, a commercially available polished silicon wafer (a p-type silicon wafer having a diameter of 200 mm, a crystal orientation of <100>, and a resistivity of 0.1 Ω·cm or more and less than 100 Ω·cm) was subjected to the pretreatment X, the SC-1 cleaning, and then the IPA vapor drying, and the resulting silicon wafer was cut into 32-mm squares, thereby preparing test samples. More specifically, as the conditions 1 and the conditions 2 in the pretreatment X, the conditions 1A and the conditions 2A were respectively employed.

A hydrogen fluoride process was performed on each test sample so that an oxide film on the silicon wafer was removed. Thereafter, the test sample was polished using the standard slurry II as a polishing slurry under conditions 3, and a removal rate reference value r₀ was calculated from a difference in the weight of the test sample between before and after the polishing. Specifically, as the conditions 3, conditions 3A described below were employed.

A hydrogen fluoride process was performed on each test sample so that an oxide film on the silicon wafer was removed. Thereafter, the test sample was polished using the polishing slurry Sx under the conditions 3, and a removal rate measured value rx was calculated from a difference in the weight of the test sample between before and after the polishing. Specifically, as the conditions 3, conditions 3A described below were employed.

From the obtained results, a polishing rate index Rx of the polishing slurry Sx was calculated from an equation: Rx = (rx/r₀) × 100.

### [Conditions 3A]

Polishing apparatus: table top polishing apparatus, model "EJ-380IN," manufactured by Engis Japan Corporation Polishing pad: a polishing pad, trade name "POLYPAS27NX" manufactured by Fujibo Ehime Co., Ltd.
Polishing load: 15 kPa
Rotation rate of surface plate: 30 rpm
Rotation rate of head: 30 rpm
Temperature of polishing slurry: 20°C
Supply rate of polishing slurry: 0.12 liter/min (free-flowing)
Polishing time: 30 minutes

Table 2 indicates the results. Table 2 also indicates values of Rp/Rf in the examples and comparative examples.

### <Polishing of Silicon Wafer>

In the examples and the comparative examples below, a commercially available polished silicon wafer (a P-type silicon wafer having a diameter of 300 mm, a crystal orientation of <100>, and a resistivity of 0.1 Ω·cm or more and less than 100 Ω·cm) was subjected to the pretreatment X, the SC-1 cleaning, and then the IPA vapor drying, and the resulting silicon wafer was polished. More specifically, as the conditions 1 and the conditions 2 in the pretreatment X, the conditions 1A and the conditions 2A described above were respectively employed.

### (Example 1)

### (1) Intermediate Polishing Step

The silicon wafer was polished with the intermediate polishing slurry Sp under the conditions 1A. Next, the silicon wafer was rinsed with a rinse solution having a composition indicated in Table 1, and was polished with the intermediate polishing slurry Sp under the conditions 2A. As the intermediate polishing slurry Sp in this example, the polishing slurry A was used in the two steps described above, as indicated in Table 2.

### (2) Final Polishing Step

The silicon wafer that had been subjected to the intermediate polishing step was polished with the final polishing slurry Sf under the conditions 2B. As the final polishing slurry Sf in this example, the polishing slurry H was used, as indicated in Table 2.

### (Examples 2 to 7)

As the intermediate polishing slurry Sp and the final polishing slurry Sf, polishing slurries of types indicated in Table 2 were used. Except for this aspect, the intermediate polishing step and the final polishing step of the silicon wafer were performed in the same manner as that in Example 1.

### (Comparative Examples 1 to 3)

As the intermediate polishing slurry Sp and the final polishing slurry Sf in Example 1, polishing slurries of types indicated in Table 2 were used. Except for this aspect, the intermediate polishing step and the final polishing step of the silicon wafer were performed in the same manner as that in Example 1.

The silicon wafers of the examples that had been subjected to the final polishing step were subjected to SC-1 cleaning and the IPA vapor drying, and thereafter, haze evaluation and evaluation of the number of micro particles were performed.

### <Haze Evaluation>

A haze value (ppm) was measured by using a wafer inspection apparatus (manufactured by KLA-Tencor, trade name "Surfscan SP2") in a DWO mode. The obtained results were converted to relative values using the haze value in Comparative Example 1 as 100%, and the obtained relative values are indicated in Table 2.

### <Evaluation of Number of Micro Particles>

The number of LPD-Ns in the surface (polished surface) of the silicon wafer in each example was measured by using a wafer inspection apparatus (manufactured by KLA-Tencor, trade name "Surfscan SP2") in a DCO mode of the apparatus. The measured number of LPD-Ns (LPD-N number) was converted to relative values using the LPD-N number in Comparative Example 1 as 100%, and the obtained relative values are indicated in Table 2. The term "unmeasurable" in columns for the LPD-N number in Table 2 means that data overload occurs in measuring the LPD-N number with the wafer inspection apparatus, that is, the LPD-N number exceeds an upper limit of the measurement.

**[Table 2]**

| | Polishing slurry | | Relative haze | | | Polishing rate | | | Haze [%] | LPD-N number [%] |
|---|---|---|---|---|---|---|---|---|---|---|
| | Sp | Sf | Hp | Hf | Hp/Hf | Rp | Rf | Rp/Rf | | |
| Example 1 | A | H | 198 | 100 | 2.0 | 322 | 100 | 3.2 | 100 | 43 |
| Example 2 | B | H | 410 | 100 | 4.1 | 392 | 100 | 3.9 | 100 | 36 |
| Example 3 | C | H | 281 | 100 | 2.8 | 415 | 100 | 4.1 | 102 | 57 |
| Example 4 | A | I | 198 | 91 | 2.2 | 322 | 64 | 5.0 | 91 | 34 |
| Example 5 | A | J | 198 | 96 | 2.1 | 322 | 56 | 5.7 | 98 | 50 |
| Example 6 | B | J | 410 | 96 | 4.3 | 392 | 56 | 7.0 | 103 | 50 |
| Example 7 | D | J | 210 | 96 | 2.2 | 378 | 56 | 6.7 | 95 | 77 |
| Comparative Example 1 | E | H | 688 | 100 | 6.9 | 430 | 100 | 4.3 | 100 | 100 |
| Comparative Example 2 | F | H | >1000 | 100 | >10.0 | 442 | 100 | 4.4 | 99 | 114 |
| Comparative Example 3 | G | J | >1000 | 96 | >10.4 | >1000 | 56 | >17.9 | 135 | unmeasurable |

As indicated in Table 2, the silicon wafers of Examples 1 to 7 each of which was polished with the polishing slurries Sp and Sf having an Hp/Hf value of more than 1 and less than 6.8 exhibited substantially equal or reduced haze and a definitely reduced LPD-N number, as compared to Comparative Example 1.

On the other hand, the silicon wafers of Comparative Examples 2 and 3 each of which was polished with the polishing slurries Sp and Sf having an Hp/Hf value of 6.8 or more exhibited definitely degraded surface grade in terms of one or both of haze and the LPD-N number, as compared to the silicon wafers of Examples 1 to 7.

Specific examples of the present invention have been described in detail hereinbefore, but are merely illustrative examples, and are not intended to limit the scope of claims. The techniques described in the scope of claims include various modifications and changes of the above exemplified specific examples.

## Claims

1. A method for polishing a silicon wafer, the method comprising:
an intermediate polishing step of polishing a silicon wafer with a polishing slurry Sp containing abrasive grains and a water-soluble polymer; and
a final polishing step of polishing the silicon wafer with a polishing slurry Sf containing abrasive grains and a water-soluble polymer, the final polishing step being performed after the intermediate polishing step, **characterized in that**
the polishing slurry Sp contains the water-soluble polymer having a weight-average molecular weight of 60 × 10⁴ or less,
the polishing slurry Sf contains the water-soluble polymer having a weight-average molecular weight of 60 × 10⁴ or less and further contains a surfactant, and
the polishing slurry Sp has a relative haze Hp greater than a relative haze Hf of the polishing slurry Sf and less than 6.8 times as high as the relative haze Hf of the polishing slurry Sf,
wherein the relative haze Hp is a value calculated in accordance with an equation: Hp = (hp/h₀) × 100 from a haze value h₀ obtained in the case of polishing the silicon wafer with a standard slurry II described later and a haze value hp obtained in the case of polishing the silicon wafer with the standard slurry II and then further polishing the silicon wafer with the polishing slurry Sp and the relative haze Hf is a value calculated in accordance with an equation: Hp = (hp/h₀) × 100 from a haze value h₀ obtained in the case of polishing the silicon wafer with a standard slurry II described later and a haze_ value hp obtained in the case of polishing the silicon wafer with the standard slurry II and then further polishing the silicon wafer with the polishing slurry Sf.

2. The method for polishing a silicon wafer according to claim 1, wherein the polishing slurry Sp contains a water-soluble polymer having a weight-average molecular weight of from 1 × 10⁴ to 60 × 10⁴.

3. The method for polishing a silicon wafer according to claim 1 or 2, wherein the polishing slurry Sf contains a surfactant having a weight-average molecular weight of from 200 to less than 10000.

4. The method for polishing a silicon wafer according to any one of claims 1 to 3, wherein the polishing slurry Sf has a relative haze Hf of 120 or less.

5. The method for polishing a silicon wafer according to any one of claims 1 to 4, wherein the polishing slurry Sp has a relative haze Hp of more than 120 to 500.

## Patentansprüche

1. Verfahren zum Polieren eines Silizium-Wafers, wobei das Verfahren umfasst:
einen Schritt zum Zwischenpolieren, in dem ein Siliziumwafer mit einer Polier-Aufschlämmung Sp poliert wird, die Schleifkörner und ein wasserlösliches Polymer enthält; sowie
einen Schritt zum abschließenden Polieren, in dem der Siliziumwafer mit einer Polier-Aufschlämmung Sf poliert wird, die Schleifkörner und ein wasserlösliches Polymer enthält, wobei der Schritt zum abschließenden Polieren nach dem Schritt zum Zwischenpolieren durchgeführt wird, **dadurch gekennzeichnet, dass**
die Polier-Aufschlämmung Sp das wasserlösliche Polymer mit einer gewichtsmittleren Molmasse von 60 × 10⁴ oder weniger enthält,
die Polier-Aufschlämmung Sf das wasserlösliche Polymer mit einer gewichtsmittleren Molmasse von 60 × 10⁴ oder weniger enthält und des Weiteren ein Tensid enthält, und
die Polier-Aufschlämmung Sp eine relative Trübung Hp aufweist, die größer ist als eine relative Trübung Hf der Polier-Aufschlämmung Sf und weniger als das 6,8-fache so hoch ist wie die relative Trübung Hf der Polier-Aufschlämmung Sf,
wobei die relative Trübung Hp ein Wert ist, der gemäß einer Gleichung Hp = (hp/h0) x 100 anhand eines Trübungswertes ho, der sich beim Polieren des Silizium-Wafers mit einer weiter unten beschriebenen Standard-Aufschlämmung II ergibt, und eines Trübungswertes hp berechnet wird, der sich beim Polieren des Silizium-Wafers mit der Standard-Aufschlämmung II und anschließendem weiteren Polieren des Siliziumwafers mit der Polier-Aufschlämmung Sp ergibt, und die relative Trübung Hf ein Wert ist, der gemäß einer Gleichung Hp = (hp/h₀) x 100 anhand eines Trübungswertes h₀, der sich beim Polieren des Silizium-Wafers mit einer weiter unten beschriebenen Standard-Aufschlämmung II ergibt, und eines Trübungswertes hp berechnet wird, der sich beim Polieren des Silizium-Wafers mit der Standard-Aufschlämmung II und anschließendem weiteren Polieren des Siliziumwafers mit der Polier-Aufschlämmung Sf ergibt.

2. Verfahren zum Polieren eines Silizium-Wafers nach Anspruch 1, wobei die Polier-Aufschlämmung Sp ein wasserlösliches Polymer mit einer gewichtsmittleren Molmasse von 1 × 10⁴ bis 60x 10⁴ enthält.

3. Verfahren zum Polieren eines Silizium-Wafers nach Anspruch 1 oder 2, wobei die Polier-Aufschlämmung Sf ein Tensid mit einer gewichtsmittleren Molmasse von 200 bis weniger als 10.000 enthält.

4. Verfahren zum Polieren eines Silizium-Wafers nach einem der Ansprüche 1 bis 3, wobei die Polier-Aufschlämmung Sf eine relative Trübung Hf von 120 oder weniger aufweist.

5. Verfahren zum Polieren eines Silizium-Wafers nach einem der Ansprüche 1 bis 4, wobei die Polier-Aufschlämmung Sp eine relative Trübung Hp von mehr als 120 bis 500 aufweist.

## Revendications

1. Procédé de polissage d'une plaquette de silicium, le procédé comprenant :
une étape de polissage intermédiaire consistant à polir une plaquette de silicium avec une suspension de polissage Sp contenant des grains abrasifs et un polymère soluble dans l'eau ; et
une étape de polissage finale consistant à polir la plaquette de silicium avec une suspension de polissage Sf contenant des grains abrasifs et un polymère soluble dans l'eau, l'étape de polissage finale étant réalisée après l'étape de polissage intermédiaire, **caractérisé en ce que**
la suspension de polissage Sp contient le polymère soluble dans l'eau ayant un poids moléculaire moyen en poids de 60 × 10⁴ ou moins,
la suspension de polissage Sf contient le polymère soluble dans l'eau ayant un poids moléculaire moyen en poids de 60 × 10⁴ ou moins et contient en outre un tensioactif, et
la suspension de polissage Sp présente un voile relatif Hp supérieur à un voile relatif Hf de la suspension de polissage Sf et inférieur à 6,8 fois le voile relatif Hf de la suspension de polissage Sf,
dans lequel le voile relatif Hp est une valeur calculée conformément à une équation :
Hp = (hp/h₀) x 100 à partir d'une valeur de voile h₀ obtenue dans le cas d'un polissage de la plaquette de silicium avec une suspension standard II décrite plus tard et d'une valeur de voile hp obtenue dans le cas d'un polissage de la plaquette de silicium avec la suspension standard II, puis d'un polissage supplémentaire de la plaquette de silicium avec la suspension de polissage Sp et le voile relatif Hf est une valeur calculée conformément à une équation : Hp = (hp/h₀) x 100 à partir d'une valeur de voile h₀ obtenue dans le cas d'un polissage de la plaquette de silicium avec une suspension standard II décrite plus tard et d'une valeur de voile hp obtenue dans le cas d'un polissage de la plaquette de silicium avec la suspension standard II puis d'un polissage supplémentaire de la plaquette de silicium avec la suspension de polissage Sf.

2. Procédé de polissage d'une plaquette de silicium selon la revendication 1, dans lequel la suspension de polissage Sp contient un polymère soluble dans l'eau ayant un poids moléculaire moyen en poids de 1 × 10⁴ à 60 × 10⁴.

3. Procédé de polissage d'une plaquette de silicium selon la revendication 1 ou 2, dans lequel la suspension de polissage Sf contient un tensioactif ayant un poids moléculaire moyen en poids de 200 à moins de 10 000.

4. Procédé de polissage d'une plaquette de silicium selon l'une quelconque des revendications 1 à 3, dans lequel la suspension de polissage Sf présente un voile relatif Hf de 120 ou moins.

5. Procédé de polissage d'une plaquette de silicium selon l'une quelconque des revendications 1 à 4, dans lequel la suspension de polissage Sp a un voile relatif Hp supérieur à 120 à 500.
